# EUROPEAN PATENT APPLICATION

(11) **EP 0 718 964 A2**
(43) Date of publication of application: **26.06.1996**
(21) Application number: 95120187.0
(22) Date of filing: 20.12.1995
(51) Int. Cl.: H03D 7/16, H03J 5/24, H03B 5/18

(54) **Switchable oscillator circuit and method**

(30) Priority: 20.12.1994 US 359523
(71) Applicant: FUJITSU COMPOUND SEMICONDUCTOR, INC., San Jose, California 95131-1138 (US)
(72) Inventor: Kennan, Wayne, Palo Alto, California 94301 (US)
(74) Representative: Stebbing, Timothy Charles

(57) **Abstract**

A monolithic microwave integrated circuit (MMIC) downconverter for a direct broadcast satellite low noise block downconverter has a mixer that produces sum and difference frequency signals from an oscillator signal and a radio frequency (RF) signal. An intermediate frequency (IF) signal is obtained by selecting the difference signal of the sum and difference frequency signals using a low pass filter. An amplifier circuit coupled to the low pass filter amplifies the IF signal from the low pass filter. A switchable oscillator frequency signal circuit is connected to the mixer, providing one of two different oscillator frequency signals for mixing with the radio frequency signal.

## Description

This invention relates to switchable oscillator circuits and to a method of switching between different oscillator frequencies by using such circuits. More particularly, but not exclusively, the invention relates to fixed-frequency oscillators used in Gallium Arsenide Monolithic Microwave Integrated Circuit (MMIC) downconverters for Low Noise Block Downconverters of Direct Broadcast Satellite (DBS) television systems.

Direct Broadcast Satellite television transmission receivers comprise a Low Noise Block Downconverter (LNB) mounted on an antenna or satellite dish connected, via coaxial cable, to an indoor tuner attached to a television set or VCR. The LNB is connected to the antenna or dish and converts the satellite signal received by the antenna to a frequency and signal level suitable for processing by the tuner and television or VCR electronics.

The Low Noise Block Downconverter assembly typically includes a monolithic microwave integrated circuit (MMIC) downconverter mounted on a printed circuit board along with support circuitry, additional amplifier stages and filters to provide increased amplification and reduced front end noise.

Typically, the LNB Downconverter receives radio frequencies of approximately 11 GHz to 12 GHz and first amplifies the signals through several high electron mobility transistors (HEMTs) and two amplifier stages in the MMIC. The MMIC also downconverts the RF signals to an intermediate frequency (IF) of approximately 1000 MHz in a mixer, then amplifies the IF signal. The mixer operates by combining the received radio frequency (RF) signals with an internal frequency reference produced by a local oscillator (LO) as is known in the art. The IF signals are the difference between the RF and LO frequency signals.

A new Direct Broadcast Satellite system operates over a broad RF range of 10.7 GHz to 12.75 GHz. Using one local oscillator frequency in the mixer would produce IF signals that are too broad and high in frequency to utilize existing converter box and coaxial cable technology. A solution is to use two separate local oscillator frequencies.

One design approach for multiple frequency local oscillators, as described in the paper "Fast Switching X and Ku Band Multi Frequency Dielectric Resonator Oscillator Using a Single GaAs FET" by A.P.S Khanna and R. Soohoo and published in the IEEE MTT-S Digest (0149-645X/87/0000-0189), is to use one common source GaAs field effect transistor (FET) oscillator and insert switches, such as PIN (positive-intrinsic-negative) diodes, between the gate of the GaAs FET oscillator and several dielectric resonators. A disadvantage of this approach is that the PIN diodes are relatively expensive and cannot be integrated into most GaAs MMIC fabrication processes. Additionally, PIN diodes have high current requirements which is undesirable in applications with strict current limitations. The PIN diodes could be replaced with FET switches for GaAs MMIC fabrication, but the loss in the FET switches would degrade the performance of the oscillator.

The present invention provides a technique to implement a two frequency local oscillator with good switching characteristics and at a low cost. The oscillator circuit switches between two different frequencies without requiring conventional switches. The RF band of the DBS system is separated into two bands such that when each RF band is mixed with the appropriate oscillator frequency, an IF bandwidth capable of being processed by currently available hardware is produced.

The switched oscillator consists of two FET oscillators with a common output. It is controlled by a voltage applied at the gate of each FET. When the gate voltage is zero volts, the FET oscillator oscillates at a frequency determined by a dielectric resonator. When the gate voltage is sufficiently negative, the FET oscillator is "pinched-off" and little or no current flows through the device. At pinch-off, oscillation cannot occur. By applying zero volts to the gate of one FET and a negative voltage (at pinch-off) to the gate of the second FET, the switched oscillator provides two oscillation frequencies. Another advantage of the switched oscillator is that the device does not draw any bias current at pinch-off which conserves DC power. Additionally, the output impedance of the FET is extremely high at pinch-off or effectively an open circuit. Therefore, the pinched-off oscillator does not load, attenuate or interfere with the output signal of the adjacent operational oscillator.

The circuit can be implemented in a GaAs MMIC downconverter with supporting circuitry in an LNB. This implementation allows existing converter box and coaxial cable designs to be utilized with the new DBS system. The MMIC comprises a mixer circuit that combines one local oscillator signal with one radio frequency band and the second local oscillator signal with another radio frequency band to produce sum and difference frequency signals. An intermediate frequency signal (the difference signal) is selected by a low pass filter coupled to the mixer circuit. An amplifier circuit amplifies the intermediate frequency signal from the low pass filter for an output signal of the MMIC.

According to one aspect of the invention, there is provided a switchable oscillator circuit for generating microwave energy at a selected one of a plurality of microwave frequencies, comprising:
a plurality of field effect transistor (FET) oscillators, operable for oscillation at different microwave frequencies, each FET oscillator comprising an input and output, and the outputs of the FET oscillators being connected together;
a bias supply connected to the outputs of the FET oscillators;
first and second inputs, each for receiving either a first or second potential; and
wherein the FET oscillators each comprise a FET responsive to a first potential for enabling the corresponding FET oscillator to oscillate and responsive to a second potential for disabling or pinching-off the corresponding FET oscillator.

According to another aspect of the invention, there is provided a method of switching between oscillator frequencies of at least first and second field effect transistor (FET) oscillators, comprising the steps of:
connecting the outputs of each oscillator together to a common output;
applying a first potential to the input of the first FET oscillator to cause oscillation thereof while applying a second potential to the input of the second FET oscillator to cause pinch-off thereof, thereby generating a first oscillation frequency at the common output; and
the applying a first potential to the input of the first FET oscillator to cause pinch-off thereof, while applying a second potential to the input of the second FET oscillator to cause oscillation thereof, thereby generating a second oscillation frequency at the common output.

The present invention also embraces a monolithic microwave integrated circuit (MMIC) downconverter for providing lower frequency output signals derived from radio frequency input signals, comprising:
a mixer circuit for producing sum and difference frequency signals from an oscillator signal and a radio frequency signal from the input signals;
a low pass filter connected to the mixer circuit for selecting an intermediate frequency signal from one of the sum and difference frequency signals;
an amplifier circuit connected to the low pass filter for amplifying the intermediate frequency signal for the output signals; and
a switchable oscillator frequency signal circuit for providing either a first or a second oscillator signal, as the oscillator signal to the mixer circuit.

Reference is made, by way of example, to the accompanying drawings in which:
FIG. 1 is a block diagram of a Low Noise Block Downconverter (LNB) system to which the present invention may be applied;
FIG. 2 depicts the portion of the monolithic microwave integrated circuit (MMIC) and LNB at 23 in FIG. 1, which embodies the present invention; and
FIG. 3 depicts an alternate embodiment of the portion of the MMIC and LNB at 23 in FIG. 1.

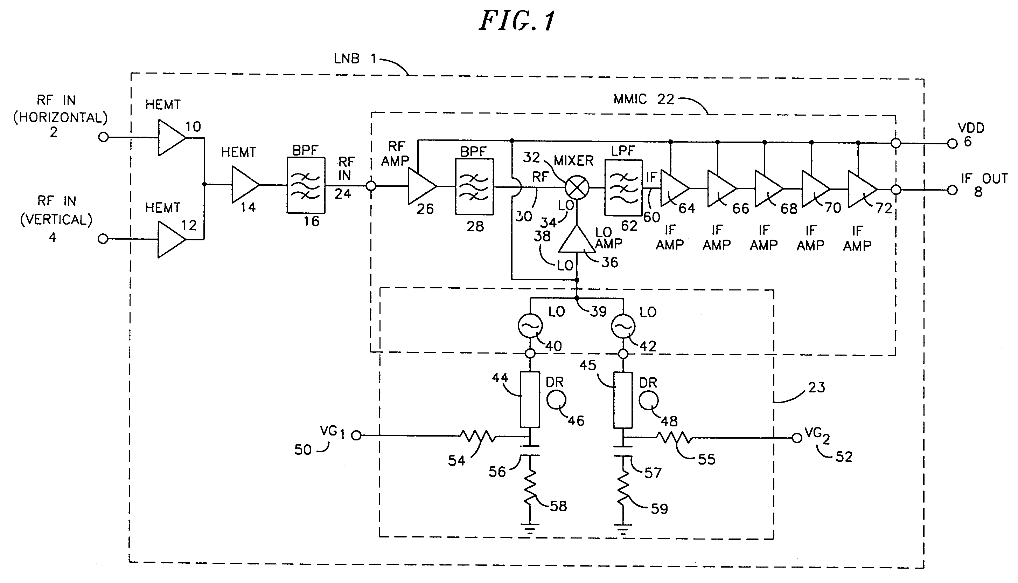

FIG. 1 illustrates a block diagram of a Low Noise Block Downconverter, LNB 1, for use in the new Direct Broadcast Satellite (DBS) receiver system. The radio frequency (RF) input is received by an antenna or dish (not shown) from a satellite transmission. The RF input may be horizontally polarized, RF IN (Horizontal) 2, or vertically polarized, RF IN (Vertical) 4, depending on the broadcast channel to which the television is tuned. The LNB Downconverter 1 is mounted on the antenna. It converts the received RF signal frequency to an intermediate frequency and amplifies the signal for processing by receiver electronics (not shown) inside, for example, the home.

The RF IN (Horizontal) 2 or RF IN (Vertical) 4 are within the frequency band 10.7 GHz to 12.75 GHz and are received by high electron mobility transistors (HEMTs), HEMT 10 and HEMT 12 respectively, for amplification of the signal. The HEMTs provide high frequency, low noise amplification of the RF signals. The amplified RF IN (Horizontal) 2 or RF IN (Vertical) 4 signal is further amplified by HEMT 14. The amplified RF signal is filtered by the BPF 16, an image-reject band pass filter, to remove unwanted signals from other sources or noise produced by the HEMTs outside of the RF signal frequency band. The output, RF IN 24, is input to the MMIC 22 for downconversion to an intermediate frequency (IF) signal, IF OUT 8, for processing by the receiver electronics.

The MMIC 22 receives the RF IN 24 and amplifies the signal in the RF AMP 26. The amplified RF signal is filtered in the BPF 28, an image-reject band pass filter, to reduce noise produced by the RF AMP 26 in the image band. The filtered and amplified RF signal, RF 30, is input to the mixer 32 where it is combined with local oscillator signal, LO 34, to produce sum and difference frequency signals of the RF 30 and LO 34 signals. The LPF 62, a low pass filter, selects an intermediate frequency signal, which is the difference signal, and provides it to IF amplifier, IF AMP 64. The amplified intermediate frequency signal is further amplified in four additional amplifier stages within the MMIC 22 comprising IF AMP 66, IF AMP 68, IF AMP 70, and IF AMP 72. The amplified signal, IF OUT 8, is then output to a converter box, or television or VCR receiver electronics for processing.

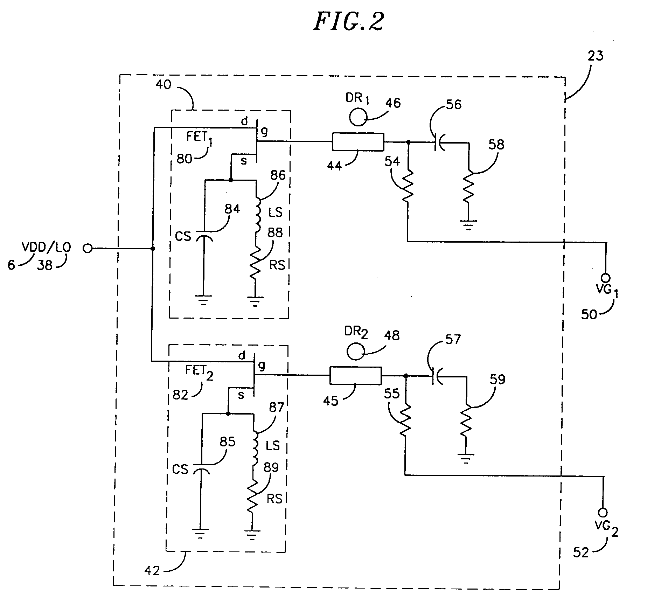

FIG. 2 illustrates portion 23 of the MMIC 22 and is referenced in the following discussion.

The mixer 32 combines the RF signal 30 with the amplified LO signal 34. The local oscillator (LO) signal 38 is one of two frequencies, 9.75 GHz or 10.6 GHz, and is connected to the input of the LO amplifier, LO AMP 36, which produces an amplified local oscillator (LO) signal 34. A spectrum of frequencies from the sum and difference of the RF signal 30 and LO signal 34 and harmonics are generated at the output of the mixer 32. The low pass filter, LPF 62, attenuates all but the difference frequencies to provide an intermediate frequency (IF) signal 60. Combining an RF signal 30 in the first frequency band, 10.7 GHz to 11.7 GHz, with the 9.75 GHz LO frequency creates an IF signal 60 bandwidth of 950 MHz to 1950 MHz. An RF signal in the second frequency band, 11.7 GHz to 12.75 GHz, combined with the 10.6 GHz LO frequency produces an IF bandwidth of 1100 MHz to 2150 MHz.

The LO signal 34 is generated by a switchable oscillator circuit 23 and amplified by the LO amplifier, LO AMP 36. The switchable oscillator circuit 23 is comprised of local oscillators 40 and 42, internal to the MMIC 22, and transmission lines 44 and 45 connected to the respective local oscillators, dielectric resonators 46 and 48 coupled to the respective transmission lines, bias resistors 54 and 55 connected in parallel with bypass capacitors 56 and 57 and termination resistors 58 and 59 and to the other end of the transmission lines. The termination resistors 58 and 59 are 50 ohms and prevent unwanted oscillations at undesirable frequencies. Inputs for receiving a voltage VG1 50 or VG2 52 are connected to the respective bias resistors 54 and 55.

The local oscillators 40 and 42 are comprised of a FET (FET1 80 or FET2 82) in a common source configuration with source inductors, LS 86 and LS 87, in series with source bias resistors, RS 88 and RS 89, and both connected in parallel with source capacitors, CS 84 and CS 85, and connected to the source, s, of the FET. The FET1 80 and FET2 82 are self-biased in a conventional manner with the gate to source voltage at the source, s, determined by the drain current through the source bias resistors, RS 88 and RS 89. The reactive feedback circuitry, comprised of the source capacitors, CS 84 and CS 85, in conjunction with the source inductors, LS 86 and LS 87, and source resistors, RS 88 and RS 89, creates a negative resistance within the device allowing FET1 80 and FET2 82 to oscillate. The gate, g, of FET1 80 and FET2 82 is connected to the transmission lines 44 and 45, respectively, to which the dielectric resonators 46 and 48 are respectively coupled for providing a stable oscillation frequency. The drains, d, of FET1 80 and FET2 82 are connected together at 39 and to the LO amplifier, LO AMP 36, as well as the bias supply, VDD 6.

The switchable oscillator 23 provides one of two local oscillator frequencies, 9.75 GHz from oscillator LO 40 or 10.6 GHz from oscillator LO 42, for mixing with the RF signal 30 as described above. Switching between the two oscillator frequencies is achieved with pinch-off control of the oscillator FETs, 80 and 82.

The concept of pinch-off control of a single oscillator, LO 40, is illustrated with the following example. The following is a description of oscillator LO 40. It will be understood that oscillator LO 42 operates in the same manner as oscillator LO 40 and the description will not be repeated. With a voltage VG1 50 equal to zero volts applied to the gate input, g, of the FET1 80 through resistor 54, the FET oscillator, LO 40, will oscillate at the frequency of the dielectric resonator DR1 46 while the bias voltage, VDD 6, is applied. With the voltage VG1 50 equal to a sufficiently negative voltage applied to the gate input, g, of the FET1 80 through resistor 54, the current flow within the device, FET1 80, from the drain, d, to the source, s, is reduced to essentially zero. As is known in the art, this occurs because the internal conducting channel of the device from the drain, d, to the source, s, is constricted or "pinched-off" by the widening nonconducting depletion regions that normally separate the gate, g, from the channel. The negative voltage sufficient to cause this condition is called the pinch-off voltage, Vp. At pinch-off, the LO 40 is not oscillating, removing the possibility of electrical interference, and bias current is not being drawn, conserving DC power. The output impedance of FET1 80 is extremely high at pinch-off such that it is effectively an open circuit. Therefore, at pinch-off, LO 40 will not load, attenuate or interfere with the output signal of the adjacent oscillating LO 42.

One of the oscillator frequencies is obtained by applying VG1 equal to zero volts to the gate, g, of FET1 80 while applying VG2 equal to Vp volts to the gate, g, of FET2 82. The other oscillator frequency is obtained by applying VG1 equal to Vp volts to the gate, g, of FET1 80 while applying VG2 equal to zero volts to the gate, g, of FET2 82. The voltages VG1 50 and VG2 52 are controlled by circuitry within the LNB 1 (not shown) that receives a control signal through a coaxial cable from the set top converter or indoor tuner and applies the appropriate voltage levels to the inputs of the FET oscillators to switch to the proper oscillator frequency depending on the channel that is selected.

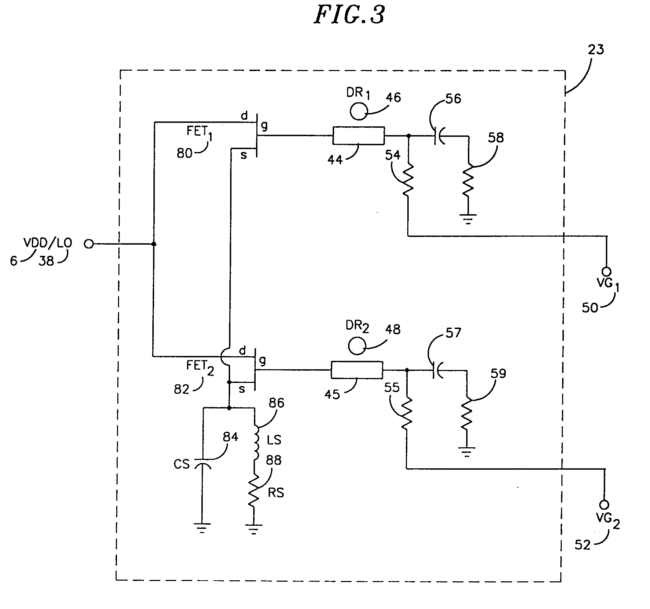

The alternate embodiment of FIG. 3 provides the same function as the circuit depicted in FIG. 2 with fewer components, since the source capacitor, CS 84, source inductor, LS 86 and source bias resistor, RS 88, are common to FET1 80 and FET2 82. As shown in FIG. 3, the source inductor, LS 86 is connected in series with the source bias resistor, RS 88 and both are connected in parallel with the source capacitor, CS 84 and connected to the sources, s, of both FET1 80 and FET2 82. The remaining circuitry is connected in the same manner as that of the embodiment described for FIG. 2.

The above description applies to an n-channel depletion mode FET. An n-channel enhancement mode FET could be utilized within the switchable oscillator circuit in place of the depletion mode devices FET1 80 and FET2 82. The source bias resistors RS 88 and RS 89 of the embodiment of FIG. 2 or RS 88 of the embodiment of FIG. 3 are not required for self-biasing of the enhancement mode FET. Also a negative voltage source is not required as the threshold voltage (analogous to the pinch-off voltage of the depletion mode device) i.e., the voltage at which the drain, d, to source, s, current is essentially zero, is approximately zero volts. A positive voltage applied to the gate, g, of the enhancement mode FET turns on the device allowing conduction of drain current through the FET.

The MMIC 22 of FIG. 1 is fabricated from Gallium Arsenide, GaAs, and assembled into a single package with input terminals for the radio frequency signal RF IN 24, the bias supply VDD 6, and the inputs to the local oscillators LO 40 and LO 42, an output terminal for the intermediate frequency output signal IF OUT 8, and three ground terminals (not shown, but depicted by ground symbols). The ground symbols are representative of a reference potential. The bias supply input terminal is connected to the active load and amplifier circuit IF AMP 64, the RF AMP 26, the local oscillators LO 40 and LO 42, and the IF signal amplifiers IF AMP 66, IF AMP 68, IF AMP 70, and IF AMP 72 for supplying the DC bias voltage.

While the invention has been described and an embodiment disclosed, it is anticipated that other modifications and adaptations will occur to those skilled in the art without departing from the scope of the invention. For example, although the invention is applied to Gallium Arsenide MMIC technology, it can be applied to other semiconductor technologies in monolithic or hybrid form. An n-channel FET has been described in the embodiments of FIG. 2 and FIG. 3; however, a complementary p-channel FET could be utilized instead of the n-channel device. The p-channel FET operation is the same as that of the n-channel device except that pinch-off results from a sufficiently positive voltage applied to the gate input and the currents are reversed. Also, the above-described embodiments employ two oscillation frequencies; however, additional frequencies can be obtained by connecting additional local oscillators at 39 and providing supporting circuitry and a gate bias voltage for each within the LNB 1 (in this case, if desired, the potential for causing oscillation can be successively applied to a different one of the FET oscillators whilst applying a potential to cause pinch-off to the inputs of the remaining FET oscillators).

It is intended therefore that the invention be limited only by the claims appended hereto. The frequencies, voltages and other values given in the disclosure are by way of example and may be varied within the scope of the invention. Although the words connected and applied are used to refer to the connection of two components or the application of a voltage to a component, where a connection is mentioned there may be one or more components in between the voltage applied or those components connected.

## Claims

1. A monolithic microwave integrated circuit (MMIC) downconverter for providing lower frequency output signals derived from radio frequency input signals, comprising:
a mixer circuit for producing sum and difference frequency signals from an oscillator signal and a radio frequency signal from the input signals;
a low pass filter connected to the mixer circuit for selecting an intermediate frequency signal from one of the sum and difference frequency signals;
an amplifier circuit connected to the low pass filter for amplifying the intermediate frequency signal for the output signals; and
a switchable oscillator frequency signal circuit for providing either a first or a second oscillator signal, as the oscillator signal to the mixer circuit.

2. The MMIC as claimed in claim 1 wherein the switchable oscillator frequency signal circuit comprises first and second inputs for receiving two different stable frequency signals.

3. The MMIC as claimed in claim 2 wherein the MMIC is assembled into a single package comprising:
an input terminal connected to the mixer circuit;
an output terminal connected to the amplifier circuit;
a bias supply input terminal connected to the amplifier circuit; and
two different stable frequency signal input terminals connected to the switchable oscillator frequency signal circuit.

4. The MMIC as claimed in claim 3 comprising an amplifier and filter connected between the input terminal and the mixer circuit.

5. The MMIC as claimed in claim 3 or 4 comprising at least one further amplifier circuit connected between the amplifier circuit and the output terminal.

6. The MMIC as claimed in claim 2, 3, 4, or 5 wherein the switchable oscillator frequency signal circuit further comprises first and second FET oscillators, each comprising:
an input;
an output;
a field effect transistor (FET) comprising a drain/source circuit and a gate, with the gate connected to the FET oscillator input and the drain/source circuit connected to the FET oscillator output;
a capacitor connected between the drain/source circuit of the FET and a reference potential, for creating a negative resistance within the FET to allow oscillation;
an inductor, having first and second ends, connected in parallel with the capacitor, with the first end connected to the drain/source circuit of the FET; and
a resistor for self-biasing the FET, having first and second ends, with the first end connected in series with the second end of the inductor and the second end connected to a reference potential.

7. The MMIC as claimed in claim 6 wherein the outputs of the first and second FET oscillators are connected together and to the mixer circuit.

8. The MMIC as claimed in any preceding claim, wherein the MMIC is fabricated from Gallium Arsenide.

9. The MMIC as claimed in claim 2 wherein the switchable oscillator frequency signal circuit further comprises first and second FET oscillators, each comprising:
an input;
an output;
a field effect transistor (FET) comprising a drain, a source, and a gate, with the gate connected to the input and the drain connected to the output;
a source capacitor connected between the source of the FET and a reference potential for creating a negative resistance within the FET to allow oscillation;
a source inductor, having first and second ends, connected in parallel to the source capacitor with the first end connected to the source of the FET; and
a source resistor for self-biasing the FET, having first and second ends, with the first end connected in series with the second end of the source inductor and the second end connected to a reference potential.

10. The MMIC as claimed in claim 2 wherein the switchable oscillator frequency signal circuit further comprises:
first and second FET oscillators, each comprising:
an input;
an output;
a field effect transistor (FET) comprising a drain/source circuit and a gate, with the gate connected to the input and the drain/source circuit connected to the output;
a capacitor connected between the drain/source circuit of the first and second FETs and a reference potential, for creating a negative resistance within the first and second FETs to allow oscillation;
an inductor, having first and second ends, connected in parallel to the capacitor, with the first end connected to the drain/source circuit of the first and second FETs; and
a resistor for self-biasing the first and second FET, having first and second ends, with the first end connected in series with the second end of the inductor and the second end connected to a reference potential.

11. The MMIC as claimed in claim 10 wherein the outputs of the first and second FET oscillators are connected together and to the mixer circuit.

12. The MMIC as claimed in claim 2 wherein the switchable oscillator frequency signal circuit further comprises first and second FET oscillators, each comprising:
an input;
an output;
a field effect transistor (FET) comprising a drain/source circuit and a gate, with the gate connected to the FET oscillator input and the drain/source circuit connected to the FET oscillator output;
a capacitor connected between the drain/source circuit of the FET and a reference potential, for creating a negative resistance within the FET to allow oscillation; and
an inductor, having first and second ends, connected in parallel with the capacitor, with the first end connected to the drain/source circuit of the FET and the second end connected to a reference potential.

13. The MMIC as claimed in claim 2 wherein the switchable oscillator frequency signal circuit further comprises:
first and second FET oscillators, each comprising:
an input;
an output;
a field effect transistor (FET) comprising a drain/source circuit and a gate, with the gate connected to the input and the drain/source circuit connected to the output;
a capacitor connected between the drain/source circuit of the first and second FETs and a reference potential, for creating a negative resistance within the first and second FETs to allow oscillation; and
an inductor, having first and second ends, connected in parallel to the capacitor, with the first end connected to the drain/source circuit of the first and second FETs and the second end connected to a reference potential.

14. The MMIC as claimed in claim 1 wherein the switchable oscillator frequency signal circuit comprises a first oscillator for forming the first oscillator signal and a second oscillator for forming the second oscillator signal, having outputs connected together to the mixer circuit.

15. The MMIC as claimed in claim 14 wherein the first oscillator comprises a first transistor, the second oscillator comprises a second transistor, each of the first and second transistors comprises a drain/source circuit connected in common to the mixer circuit and a means for independently switching the first transistor to enable the first oscillator to provide a signal or the second transistor to enable the second oscillator to provide a signal to the mixer.

16. The MMIC as claimed in claim 14 wherein the first oscillator comprises a first transistor, the second oscillator comprises a second transistor, each of the first and second transistors comprises a drain/source circuit connected in common to the mixer circuit and a means for independently switching the first transistor to block oscillation of the first oscillator or switching the second transistor to block oscillation of the second oscillator.

17. The MMIC downconverter as claimed in any preceding claim, combined with support circuitry comprising:
first and second transmission lines, each having first and second ends, with the first ends connected respectively to first and second inputs of the switchable oscillator frequency signal circuit;
first and second dielectric resonators coupled, respectively, to the first and second transmission lines for providing stable frequencies of oscillation to the switchable oscillator frequency signal circuit;
first and second bias resistors, each having first and second ends with the first ends connected, respectively, to the second ends of the first and second transmission lines and the second end of each connected for receiving a bias signal;
first and second bypass capacitors, each having first and second ends, with the first ends connected to the second ends of, respectively, the first and second transmission lines; and
first and second termination resistors, each having first and second ends, with the first ends connected to the second ends of, respectively, the first and second bypass capacitors and the second ends connected to a reference potential.

18. A switchable oscillator circuit for generating microwave energy at a selected one of a plurality of microwave frequencies, comprising:
a plurality of field effect transistor (FET) oscillators, operable for oscillation at different microwave frequencies, each FET oscillator comprising an input and output, and the outputs of the FET oscillators being connected together;
a bias supply connected to the outputs of the FET oscillators;
first and second inputs, each for receiving either a first or second potential; and
wherein the FET oscillators each comprise a FET responsive to a first potential for enabling the corresponding FET oscillator to oscillate and responsive to a second potential for disabling or pinching-off the corresponding FET oscillator.

19. The switchable oscillator circuit as claimed in claim 18, wherein each FET oscillator further comprises:
a field effect transistor (FET) comprising a drain, a source, and a gate, with the drain connected to the output of the oscillator;
a source capacitor connected between the source of the FET and a reference potential for creating a negative resistance within the FET to allow oscillation;
a source inductor, having first and second ends, connected in parallel to the source capacitor with the first end connected to the source of the FET;
a source resistor for self-biasing the FET, having first and second ends, with the first end connected in series with the second end of the source inductor and the second end connected to a reference potential;
a transmission line having first and second ends with the first end connected to the gate of the FET;
a dielectric resonator coupled to the transmission line for providing a stable frequency of oscillation to the FET;
a bias resistor having first and second ends with the first end connected to the second end of the transmission line and the second end connected to the input of the oscillator;
a bypass capacitor having first and second ends, connected in parallel with the bias resistor, with the first end connected to the second end of the transmission line; and
a termination resistor having first and second ends with the first end connected to the second end of the bypass capacitor and the second end connected to a bias potential.

20. The switchable oscillator circuit as claimed in claim 18, wherein each FET oscillator further comprises:
a field effect transistor (FET) comprising a drain, a source, and a gate, with the drain connected to the output of the oscillator;
a source capacitor connected between the source of the FET and a reference potential for creating a negative resistance within the FET to allow oscillation;
a source inductor, having first and second ends, connected in parallel to the source capacitor with the first end connected to the source of the FET and the second end connected to a reference potential;
a transmission line having first and second ends with the first end connected to the gate of the FET;
a dielectric resonator coupled to the transmission line for providing a stable frequency of oscillation to the FET;
a bias resistor having first and second ends with the first end connected to the second end of the transmission line and the second end connected to the input of the oscillator;
a bypass capacitor having first and second ends, connected in parallel with the bias resistor, with the first end connected to the second end of the transmission line; and
a termination resistor having first and second ends with the first end connected to the second end of the bypass capacitor and the second end connected to a bias potential.

21. A method of switching between oscillator frequencies of at least first and second field effect transistor (FET) oscillators, comprising the steps of:
connecting the outputs of each oscillator together to a common output;
applying a first potential to the input of the first FET oscillator to cause oscillation thereof while applying a second potential to the input of the second FET oscillator to cause pinch-off thereof, thereby generating a first oscillation frequency at the common output; and
then applying a first potential to the input of the first FET oscillator to cause pinch-off thereof, while applying a second potential to the input of the second FET oscillator to cause oscillation thereof, thereby generating a second oscillation frequency at the common output.
